# EUROPEAN PATENT APPLICATION

(11) **EP 4 254 519 A1**
(43) Date of publication of application: **04.10.2023**
(21) Application number: 22897076.0
(22) Date of filing: 30.05.2022
(51) Int. Cl.: H01L 31/20, H01L 31/075

(54) **METHOD FOR PREPARING TUNNEL OXIDE LAYER AND AMORPHOUS SILICON THIN FILM, AND TOPCON CELL**

(30) Priority: 26.11.2021 CN 202111420983
(71) Applicant: Tongwei Solar (Meishan) Co., Ltd., Meishan, Sichuan 620041 (CN)
(72) Inventor: DENG, Mingzhang, Sichuan 620041 (CN); CHEN, Hao, Sichuan 620041 (CN); MENG, Xiajie, Sichuan 620041 (CN); XING, Guoqiang, Sichuan 620041 (CN)
(74) Representative: Marks & Clerk LLP
(86) International application number: PCT/CN2022/096067
(87) International publication number: WO 2023/092977

(57) **Abstract**

The present application relates to the technical field of solar cells, and in particular, to a method for preparing a tunnel oxide layer and an amorphous silicon thin film and a TOPCon cell. The method includes sequentially depositing a tunnel oxide layer, an intrinsic amorphous silicon thin film and a doped amorphous silicon thin film at a deposition temperature of 440 °C to 460 °C by using a PECVD device. A flow rate of silane of depositing the intrinsic amorphous silicon thin film and the doped amorphous silicon thin film is in a range of 2000 sccm to 2500 sccm. The film obtained by the above method is dense, and hydrogen atoms are better released during a subsequent annealing process, greatly mitigating the problem of film delamination. By adjusting the flow rate of silane, the growth rate of the thin film can be reduced, such that more hydrogen atoms overflow from the thin film, preventing hydrogen atoms from being stored within the thin film, and therefore effectively reducing the occurrence of film delamination resulting from hydrogen atoms accumulating and forming hydrogen gas in the later annealing process.

## Description

### CROSS-REFERENCE TO RELATED APPLICATIONS

This application claims priority to Chinese Patent Application No. 202111420983.0, filed on November 26, 2021 with Chinese patent office, entitled "METHOD FOR PREPARING TUNNEL OXIDE LAYER AND AMORPHOUS SILICON THIN FILM, AND TOPCON CELL", the content of which is hereby incorporated by reference in its entirety.

### TECHNICAL FIELD

The present application relates to the technical field of solar cells, and in particular, to a method for preparing a tunnel oxide layer and an amorphous silicon thin film and a TOPCon cell.

### BACKGROUND

N-type tunnel oxide passivating contact (TOPCon) cells are solar cells using a tunnel oxide passivated contact technology based on a selective carrier principle. A main technical route for depositing polysilicon thin films in the industry involves using Low Pressure Chemical Vapor Deposition (LPCVD) method to deposit tunnel oxide layers and amorphous silicon thin films, and subsequently, doping the thin films in an ion implantation or phosphorus diffusion manner to form phosphorus-doped polysilicon (Poly-Si) thin films.

In recent years, a method for preparing the TOPCon cells based on a tube-type PECVD (i.e., Plasma Enhanced Chemical Vapor Deposition) deposition technology and coating equipment thereof have emerged. Compared to LPCVD method, poly-Si and silicon oxide (SiOₓ) deposition by PECVD method has smaller wraparound deposition, which is advantageous for controlling the appearance and yield. Additionally, PECVD allows for the deposition of four sequential steps in a same tube of a same machine, including a tunnel oxide layer thin film, an intrinsic amorphous silicon thin film, a phosphorus-doped amorphous silicon thin film and a backside silicon oxide mask layer on a back side of TOPCon cell. And this integration of steps simplifies the process and increases equipment utilization, resulting in higher production efficiency.

However, there is a potential problem of film delamination during the process of depositing the amorphous silicon thin film using the tube-type PECVD.

### SUMMARY

The present application provides a method for preparing a tunnel oxide layer and an amorphous silicon thin film, including: sequentially depositing a tunnel oxide layer, an intrinsic amorphous silicon thin film and a doped amorphous silicon thin film at a deposition temperature of 440 °C to 460 °C by using a PECVD device,
wherein a flow rate of silane of depositing the intrinsic amorphous silicon thin film is in a range of 2000 sccm to 2500 sccm; and
a flow rate of silane of depositing the doped amorphous silicon thin film is in a range of 2000 sccm to 2500 sccm.

In some embodiments of the present application, a duty cycle of plasma pulse of depositing the intrinsic amorphous silicon thin film is 20: (500 - 600), and
a duty cycle of plasma pulse of depositing the doped amorphous silicon thin film is 20: (500 - 600).

In some embodiments of the present application, in a process of depositing the tunnel oxide layer, a flow rate of N₂O is in a range of 5500 sccm to 6500 sccm and a duty cycle of plasma pulse is 20: (900 - 1000).

In some embodiments of the present application, after depositing the doped amorphous silicon thin film, the method further includes:
annealing for 20 minutes to 60 minutes at a temperature of 600 °C to 1000 °C under a nitrogen or oxygen atmosphere.

In some embodiments of the present application, before depositing the tunnel oxide layer, the method further includes: performing a vacuum pumping and leakage detection on a furnace tube of the PECVD device.

In some embodiments of the present application, the doped amorphous silicon thin film is a phosphorus-doped amorphous silicon thin film, and in a process of depositing the phosphorus-doped amorphous silicon thin film, a flow rate of phosphorus alkane is in a range of 2000 sccm to 2500 sccm, and a flow rate of hydrogen is in a range of 5000 sccm to 5500 sccm.

In some embodiments of the present application, the doped amorphous silicon thin film is a nitrogen-doped amorphous silicon thin film, and in a process of depositing the nitrogen-doped amorphous silicon thin film, a flow rate of methane is in a range of 450 sccm to 500 sccm and a flow rate of nitrogen is in a range of 1500 sccm to 2000 sccm.

The present application further provides a method for preparing a tunnel oxide layer and an amorphous silicon thin film. The method incudes: sequentially depositing a tunnel oxide layer, an intrinsic amorphous silicon thin film and a doped amorphous silicon thin film at a deposition temperature of 440 °C to 460 °C by using a PECVD device,
wherein a duty cycle of plasma pulse of depositing the intrinsic amorphous silicon thin film is 20: (500 - 600), and
a duty cycle of plasma pulse of depositing the doped amorphous silicon thin film is 20: (500 - 600).

The present application further provides a method for preparing a tunnel oxide layer and an amorphous silicon thin film. The method includes: sequentially depositing a tunnel oxide layer, an intrinsic amorphous silicon thin film and a doped amorphous silicon thin film at a deposition temperature of 440 °C to 460 °C by using a PECVD device,
wherein in a process of depositing the intrinsic amorphous silicon thin film, a flow rate of silane is in a range of 2000 sccm to 2500 sccm, and a duty cycle of plasma pulse is 20: (500 - 600); and
in a process of depositing the doped amorphous silicon thin film, a flow rate of silane is in a range of 2000 sccm to 2500 sccm, and a duty cycle of plasma pulse is 20: (500 - 600).

The present application further provides a tunnel oxide layer and an amorphous silicon thin film, prepared by any one of the above-described methods.

The present application further provides a TOPCon cell, wherein a tunnel oxide layer and an amorphous silicon thin film of the TOPCon cell are prepared by any one of the above-described methods.

The present application further provides a TOPCon cell including the tunnel oxide layer and the amorphous silicon thin film prepared by any one of the above-described methods.

### BRIEF DESCRIPTION OF THE DRAWINGS

In order to more clearly illustrate the technical solutions of the embodiments of the present application, the accompanying drawings that need to be used in the embodiments are briefly described below, and it should be understood that the following drawings illustrate only certain embodiments of the present application, and therefore should not be considered as limiting the scope of the present application.
FIG. 1 is an appearance view of a passivated contact structure of a TOPCon cell under a microscope in Example 1 of the present application.
FIG. 2 is an appearance view of a passivated contact structure of a TOPCon cell under a microscope in Comparative Example 1 of the present application.
FIG. 3 is an appearance view of a passivated contact structure of a TOPCon cell under a microscope in Comparative Example 2 of the present application.
FIG. 4 is an appearance view of a passivated contact structure of a TOPCon cell under a microscope in Comparative Example 3 of the present application.
FIG. 5 is an appearance view of a passivated contact structure of a TOPCon cell under a microscope in Comparative Example 4 of the present application.

### DETAILED DESCRIPTION

In order to facilitate understanding of the present application, the present application will be comprehensively described with reference to the accompanying drawings. However, the present application can be implemented in many different forms and therefore is not limited to the embodiments described herein. It should be understood that the purpose of providing these embodiments is to thoroughly and comprehensively understand the disclosure of the present application.

A back side of a TOPCon cell is provided with a tunnel oxide layer passivated contact structure, which consists of a tunnel oxide layer and a doped polysilicon layer. This structure effectively reduces recombination in a metal contact area and exhibits excellent contact performance, resulting in a significant enhancement of efficiency of the solar cell. The doped polysilicon in the passivating layer and silicon oxide of Si interface of the substrate acts as a chemical passivation, reducing an interface state density between the substrate Si and the polysilicon. Most carriers are transported through the oxide layer according to the tunnel principle, and minority carriers are difficult to tunnel through the oxide layer due to barrier and polysilicon field effect. In the heavily doped polysilicon, a concentration of the majority carriers is significantly higher than that of the minority carrier. This not only reduces the probability of electron-hole recombination but also increases the conductivity, enabling selective contact for the majority carriers.

In the preparation process of the tunnel oxide passivated contact structure, a tunnel oxide layer and an amorphous silicon layer are mainly deposited by using low-pressure chemical vapor deposition (LPCVD). Subsequently, the amorphous silicon layer is doped with ion implantation or phosphorus diffusion to form a phosphorus-doped polysilicon (poly-Si) thin film.

For the ion implantation technology, the cells need to undergo a wet-cleaning process to remove metal impurities introduced from the ion injection before the annealing step which activates the phosphorus atoms in the poly-Si film and repairs the damage caused by the ion injection. In regard to the phosphorus diffusion technique, the wraparound deposition formed in the diffusion process and the wraparound deposition of the poly-Si film formed in the LPCVD deposition may cause whitening of appearance of the cells and darkening in the electroluminescence (EL) tests, which significantly affects the yield. In addition, the method is complicated and the process window is relatively narrow. In recent years, a tube-type PECVD deposition technology has emerged, poly-Si and silicon oxide (SiOₓ) deposition by PECVD method has smaller wraparound deposition, which is advantageous for controlling the appearance and yield.

After depositing the amorphous silicon thin film on a back side of the TOPCon cell using the tube-type PECVD, a severe film delamination phenomenon often occurs. The film delamination regions may form recombination centers, leading to poor passivation performance in those regions. As a result, the open-circuit voltage of the TOPCon cells may be reduced, affecting the overall photoelectric conversion efficiency of the cells.

It has been found by the applicant that the mechanism of the film delamination phenomenon of the amorphous silicon film prepared by PECVD is attributed to the presence of a significant amount of hydrogen atoms existing in the amorphous silicon layer, and in the high-temperature annealing process of converting amorphous silicon into polysilicon, the hydrogen atoms may tend to form hydrogen gas that cannot overflow out of the film, so that the film delamination phenomenon may occur.

The present application provides a method for preparing a tunnel oxide layer and an amorphous silicon thin film based on PECVD, and a TOPCon cell. The objective is to mitigate the film delamination problem that is likely to occur during the deposition of amorphous silicon thin films.

The method for preparing the tunnel oxide layer and the amorphous silicon thin film according to the embodiments of the present application and the TOPCon cell are described below.

A method for preparing a tunnel oxide layer and an amorphous silicon thin film is provided. The method includes sequentially depositing a tunnel oxide layer, an intrinsic amorphous silicon thin film and a doped amorphous silicon thin film at a deposition temperature of 440 °C to 460 °C by using a PECVD device.

The deposition temperature is set at 440 °C to 460 °C, which results in a denser film. During the subsequent annealing process, hydrogen atoms can be released effectively, greatly mitigating the problem of film delamination. During the deposition of the intrinsic amorphous silicon thin film and the doped amorphous silicon thin film, the flow rate of silane is set at 2000 sccm to 2500 sccm. A growth rate of the thin film can be reduced, such that more hydrogen atoms can overflow from the thin film, preventing hydrogen atom from being stored within the thin film, and therefore effectively reducing the phenomenon of film delamination resulting from hydrogen atoms accumulating and forming hydrogen gas in the later annealing process.

Before preparing the tunnel oxide layer and the amorphous silicon thin film, the method further includes: performing a vacuum pumping and leakage detection on a furnace tube of the PECVD device, and raising the temperature to the deposition temperature of the tunnel oxide layer.

In the present application, the deposition temperature of depositing the tunnel oxide layer, the intrinsic amorphous silicon thin film and the doped amorphous silicon thin film is in a range of 440 °C to 460 °C, for example, the deposition temperature can be in a range of 443 °C to 457 °C, 445 °C to 455 °C, or 448 °C to 452 °C, such as 440 °C, 442 °C, 445 °C, 450 °C, 453 °C, 456 °C, 458 °C, 460 °C, and so on.

The deposition temperature is set at 440 °C to 460 °C. During the deposition process, the relatively high temperature will result in a denser film. In the subsequent annealing process, hydrogen atoms can be released more effectively, greatly mitigating the problem of film delamination.

After reaching the deposition temperature, nitrous oxide (N₂O) is introduced for depositing the intrinsic amorphous silicon thin film. In one embodiment, a flow rate of nitrous oxide (N₂O) is set between 5500 sccm and 6500 sccm, and a duty cycle of plasma pulse is 20 : (900-1000). For example, the flow rate of nitrous oxide (N₂O) can be set at 5700 sccm to 6300 sccm, 5900 sccm to 6200 sccm, or 6000 sccm to 6100 sccm, such as 5500 sccm, 5600 sccm, 6000 sccm, 6200 sccm, 6300 sccm, 6500 sccm, etc. The duty cycle of plasma pulse can be set at 20 : (910 - 990), 20: (930 - 980), or 20 : (940 - 960), such as 20 : 900, 20 : 950, 20 : 1000, etc.

After the deposition of the tunnel oxide layer, silane (SiH₄) and hydrogen (H₂) are introduced to begin plasma deposition of the intrinsic amorphous silicon thin film. In the present application, a flow rate of silane is in a range of 2000 sccm to 2500 sccm, a flow rate of hydrogen is in a range of 5000 sccm to 5500 sccm. For example, the flow rate of silane can be set at 2100 sccm to 2400 sccm, 2150 sccm to 2350 sccm, or 2200 sccm to 2300 sccm, such as 2000 sccm, 2100 sccm, 2200 sccm, 2300 sccm, 2400 sccm, 2500 sccm, etc. Furthermore the flow rate of hydrogen can be set at 5100 sccm to 5400 sccm, 5150 sccm to 5350 sccm, or 5200 sccm to 5300 sccm, such as 5000 sccm, 5100 sccm, 5200 sccm, 5300 sccm, 5400 sccm, 5500 sccm, etc. And a deposition time for the intrinsic amorphous silicon thin film can be set as required thickness, for example, the deposition time can range from 7 minutes to 10 minutes.

During the deposition of the intrinsic amorphous silicon thin film, the flow rate of silane is set at 2000 sccm to 2500 sccm. This can reduce a growth rate of the thin film, allowing more hydrogen atoms to overflow from the thin film and prevent hydrogen atom from being stored within the thin film. And this greatly mitigating the problem of film delamination caused by hydrogen atoms accumulating and forming hydrogen gas in the later annealing process.

During the deposition of the intrinsic amorphous silicon thin film, a duty cycle of plasma pulse is 20: (500 - 600). For example, the duty cycle of plasma pulse can be 20 : (520 - 580), 20 : (530 - 570), or 20 : (540 - 560), such as 20 : 500, 20 : 510, 20 : 520, 20 : 530, 20 : 540, 20 : 550, 20 : 560, 20 : 570, 20 : 580, 20 : 590, 20 : 60, etc.

Adjusting the duty cycle of plasma pulse of depositing the intrinsic amorphous silicon thin film to 20 : (500 - 600) can lower a growth rate of the intrinsic amorphous silicon thin film and also mitigate the problem of film delamination resulting from hydrogen atoms accumulating and forming hydrogen gas in the later annealing process.

After depositing the intrinsic amorphous silicon thin film, the doped amorphous silicon thin film is deposited. And the doped amorphous silicon film can be either a phosphorous-doped amorphous silicon thin film or a nitrogen-doped amorphous silicon thin film, and can be selected according to requirements.

In some embodiments, depositing the phosphorous-doped amorphous silicon thin film can include following steps: introducing silane (SiH₄), phosphine (PH₃), and hydrogen (H₂), and beginning plasma deposition of the doped amorphous silicon thin film. In this embodiment, the flow rate of H₂ is in a range of 5000 sccm to 5500 sccm, the flow rate of phosphine (PH3) is in a range of 2000 sccm to 2500 sccm, and the flow rate of silane is in a range of 2000 sccm to 2500 sccm. The duty cycle of plasma pulse is set at 20: (500 - 600). For example, the flow rate of silane can be in a range of 2100 sccm to 2400 sccm, in a range of 2150 sccm to 2350 sccm, or in a range of 2200 sccm to 2300 sccm, such as 2000 sccm, 2100 sccm, 2200 sccm, 2300 sccm, 2400 sccm, 2500 sccm, etc.

In the deposition of the doped amorphous silicon thin film, the flow rate of silane is set in a range of 2000 sccm to 2500 sccm, thereby it is possible to lower the growth rate of the thin film, facilitating the release of hydrogen atoms and decreasing the generation of hydrogen gas during annealing, thereby reducing the occurrence of film delamination.

In some embodiments, during the deposition of the doped amorphous silicon thin film, the duty cycle of plasma pulse can be set to 20 : (515 - 595), 20 : (530 - 570), or 20 : (540 - 560), such as 20 : 500, 20 : 510, 20 : 520, 20 : 530, 20 : 540, 20 : 550, 20 : 560, 20 : 570, 20 : 580, 20 : 590, 20 : 600, etc.

Adjusting the duty cycle of plasma pulse to 20 : (500 - 600) during the deposition of the doped amorphous silicon thin film can mitigate the problem of film delamination resulting from hydrogen atoms accumulating and forming hydrogen gas in the later annealing process.

In some embodiments, depositing the nitrogen-doped amorphous silicon thin film can include following steps: introducing silane (SiH₄), methane (CH₄), and nitrogen gas (N₂), and beginning plasma deposition of the doped amorphous silicon thin film. In this embodiment, the flow rate of silane is in a range of 2000 sccm to 2500 sccm, the flow rate of methane is in a range of 450 sccm to 500 sccm, and the flow rate of nitrogen gas is in a range of 1500 sccm to 2000 sccm. And the duty cycle of plasma pulse is set at 20: (500-600).

In some embodiments, in the deposition of the nitrogen-doped amorphous silicon film, the flow rate of silane can be in a range of 2100 sccm to 2400 sccm, in a range of 2150 sccm to 2350 sccm, or in a range of 2250 sccm to 2300 sccm, such as 2000 sccm, 2100 sccm, 2200 sccm, 2300 sccm, 2400 sccm, 2500 sccm, and so on. The flow rate of methane can be in a range of 460 sccm to 490 sccm, in a range of 465 sccm to 475 sccm, or in a range of 470 sccm to 480 sccm, such as 450 sccm, 460 sccm, 480 sccm, 490 sccm, 500 sccm, and so on. The flow rate of nitrogen gas can be in a range of 1600 sccm to 1900 sccm, in a range of 1650 sccm to 1850 sccm, or in a range of 1700 sccm to 1800 sccm, such as 1500 sccm, 1600 sccm, 1700 sccm, 1800 sccm, 1900 sccm, 2000 sccm, and so on. In some embodiments, the duty cycle of plasma pulse can be 20 : (510 - 590), 20 : (520 - 580), or 20 : (540 - 560), such as 20 : 500, 20 : 510, 20 : 520, 20 : 530, 20 : 540, 20 : 550, 20 : 560, 20 : 570, 20 : 580, 20 : 590, 20 : 600, and so on.

In the deposition of the nitrogen-doped amorphous silicon thin film, the flow rate of silane is set in a range of 2000 sccm to 2500 sccm, which can lower the growth rate of the thin film, facilitate the release of hydrogen atoms and reduce the generation of hydrogen gas during annealing, thus reducing the occurrence of film delamination. Similarly, adjusting the duty cycle of plasma pulse to be 20 : (500 - 600) can mitigate the problem of film delamination resulting from hydrogen atoms accumulating and forming hydrogen gas in the later annealing process.

After depositing the doped amorphous silicon thin film, annealing is performed. In the embodiments of present application, the annealing is performed under nitrogen gas (N₂) or oxygen gas (O₂) annealing atmosphere. An annealing temperature ranges from 600 °C to 1000 °C, and an annealing time is in a range of 20 minutes to 60 minutes. For example, the annealing temperature can be set at in a range of 650°C to 950°C, 700°C to 900°C, or 750°C to 850°C, such as 600°C, 700°C, 800°C, 900°C, 1000°C, etc.

For the embodiment where the annealing atmosphere is oxygen gas, the oxygen can oxidize the amorphous silicon to produce a silicon dioxide film as a protective layer.

It should be noted that in other embodiments of the present application, the parameters of the annealing process may be selected as required, and are not limited to the abovementioned annealing temperature and the annealing time.

The method for preparing tunnel oxide layers and amorphous silicon thin films in the embodiments of present application includes following advantages:
In the preparation of the thin films by PECVD device, the flow rate of silicon hydride during the deposition of the intrinsic amorphous silicon films and the doped amorphous silicon films is adjusted, such that it is possible to avoid hydrogen atoms accumulating and forming hydrogen gas in the later annealing process, thereby greatly mitigating the problem of film delamination.

In some embodiments, by adjusting the duty cycle of plasma pulse of depositing the intrinsic amorphous silicon thin film and the doped amorphous silicon thin film is 20: (500 - 600), it is possible to reduce a growth rate of the film, thereby greatly mitigating the problem of film delamination.

The present application further provides a method for preparing a tunnel oxide layer and an amorphous silicon thin film, including:
sequentially depositing a tunnel oxide layer, an intrinsic amorphous silicon thin film and a doped amorphous silicon thin film at a deposition temperature of 440 °C to 460 °C by using a PECVD device, wherein a duty cycle of plasma pulse of depositing the intrinsic amorphous silicon thin film is 20: (500 - 600), and a duty cycle of plasma pulse of depositing the doped amorphous silicon thin film is 20: (500 - 600). And in this method, a flow rate of silane is in a range of 2000 sccm to 3000 sccm.

The present application further provides a method for preparing a tunnel oxide layer and an amorphous silicon thin film, including:
sequentially depositing a tunnel oxide layer, an intrinsic amorphous silicon thin film and a doped amorphous silicon thin film at a deposition temperature of 440 °C to 460 °C by using a PECVD device, wherein in a process of depositing the intrinsic amorphous silicon thin film, a flow rate of silane is in a range of 2000 sccm to 2500 sccm, and a duty cycle of plasma pulse is 20: (500 - 600); and in a process of depositing the doped amorphous silicon thin film, a flow rate of silane is in a range of 2000 sccm to 2500 sccm, and a duty cycle of plasma pulse is 20: (500 - 600). And in this method, a deposition temperature of the tunnel oxide layer is in a range of 400 °C to 460 °C.

Accordingly, depositing the tunnel oxide layer at a temperature range of 440 °C to 460 °C promotes the formation of a dense film and facilitates the release of hydrogen atoms during subsequent annealing processes, greatly mitigating the problem of film delamination. Adjusting the duty cycle of plasma pulse to 20: (500 - 600) during the deposition of both the intrinsic amorphous silicon thin film and the doped amorphous silicon thin film lowers the growth rate of the intrinsic amorphous silicon thin film and mitigates the phenomenon of film delamination resulting from hydrogen atoms accumulating and forming hydrogen gas in the later annealing process.

The present application further provides a tunnel oxide layer and an amorphous silicon thin film, prepared by the above-described methods.

The present application further provides a TOPCon cell, wherein a tunnel oxide layer and an amorphous silicon thin film of the TOPCon cell are prepared by the above-described methods.

The present application further provides a TOPCon cell including the tunnel oxide layer and the amorphous silicon thin film prepared by the above-described methods.

The structure obtained by the method for preparing tunnel oxide layers and amorphous silicon thin films effectively mitigates the problem of film delamination. As a result, the film delamination existing in the TOPCon cell is also correspondingly reduced, leading to enhanced electrical performance.

### Examples

The features and performance of the present application are further described in detail below with reference to the examples.

In Example 1 and Comparative Examples 1 to 4, before preparing the passivated contact structure of the TOPCon cell, the processes such as texturing, boron diffusion and alkaline polishing are carried out, including following steps:
(1) Texturing: preparing an N-type silicon wafer, texturing the silicon wafer by an alkaline liquid with a concentration of 1% by mass and cleaning the silicon wafer by a hydrogen peroxide solution and an alkaline liquid;
(2) Boron diffusion: putting the silicon wafer into a boron diffusion furnace and achieving boron diffusion by introducing BCl₃ at a temperature of 900 °C to 1050 °C, to form PN junction; and
(3) Alkaline polishing: removing wraparound BSG formed in the boron diffusion from the back side of the boron-diffused silicon wafer by using a chain-type HF apparatus; then transferring the silicon wafer into an alkaline polishing trough via a mechanical arm; and then removing the PN junction formed on the back side and on edges of the silicon wafer.

### Example 1

This example provides a method for preparing a passivated contact structure of a TOPCon cell mainly including following steps:
(1) performing a vacuum pumping and leakage detection on a furnace tube of a PECVD device, placing a silicon wafer inside the furnace tube of the PECVD device, and then heating to 440°C;
(2) depositing a tunnel SiO₂ layer: introducing N₂O to deposite the tunnel SiO₂ layer, wherein a flow rate of N₂O is 6000 sccm, the deposition time is 3 minutes, and a duty cycle of plasma pulse is 20 : 1000;
(3) depositing an intrinsic amorphous silicon thin film: introducing SiH₄ and H₂ and activating the plasma to deposite the intrinsic amorphous silicon thin film, wherein a flow rate of SiH₄ is 2000 sccm, a flow rate of H₂ is 5000 sccm, the deposition time is 8 minutes, and a duty cycle of plasma pulse is 20 : 500;
(4) depositing a phosphorus-doped amorphous silicon thin film: introducing SiH₄, PH₃ and H₂ and activating the plasma to deposite the phosphorus-doped amorphous silicon thin film, wherein a flow rate of SiH₄ is 2000 sccm, a flow rate of PH₃ is 2000 sccm, a flow rate of H₂ is 5000 sccm, the deposition time is 25 minutes, and a duty cycle of plasma pulse is 20 : 500; and
(5) Annealing: annealing the sample obtained in the step (4) at a temperature of 900°C for 30 minutes under nitrogen atmosphere. And a thickness of the annealed polysilicon film is 100 nm.

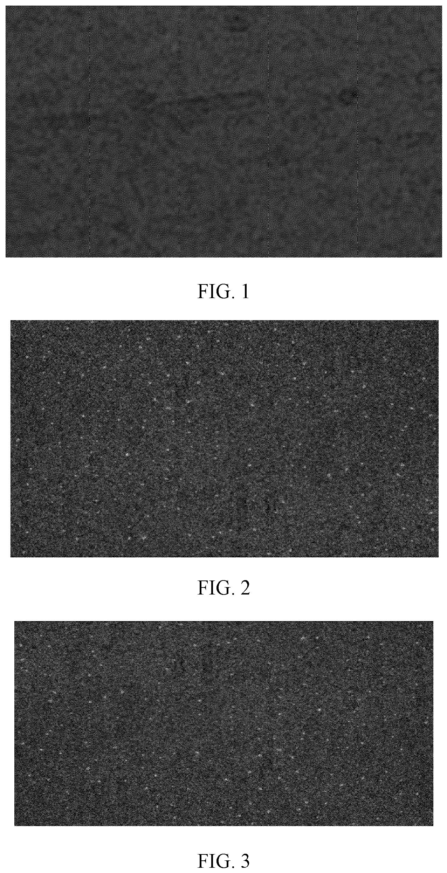

FIG. 1 shows an appearance view of the passivated contact structure of the TOPCon cell in Example 1 under a microscope.

### Comparative Example 1

This comparative example provides a method for preparing a passivated contact structure of a TOPCon cell mainly including following steps:
(1) performing a vacuum pumping and leakage detection on a furnace tube of a PECVD device, placing a silicon wafer inside the furnace tube of the PECVD device, and then heating to 440°C;
(2) depositing a tunnel SiO₂ layer: introducing N₂O to deposite the tunnel SiO₂ layer, wherein a flow rate of N₂O is 6000 sccm, the deposition time is 3 minutes, and a duty cycle of plasma pulse is 20 : 1000;
(3) depositing an intrinsic amorphous silicon thin film: introducing SiH₄ and H₂ and activating the plasma to deposite the intrinsic amorphous silicon thin film, wherein a flow rate of SiH₄ is 3000 sccm, a flow rate of H₂ is 5000 sccm, the deposition time is 7 minutes, and a duty cycle of plasma pulse is 20 : 400;
(4) depositing a phosphorus-doped amorphous silicon thin film: introducing SiH₄, PH₃ and H₂ and activating the plasma to deposite the phosphorus-doped amorphous silicon thin film, wherein a flow rate of SiH₄ is 3000 sccm, a flow rate of PH₃ is 2000 sccm, a flow rate of H₂ is 5000 sccm, the deposition time is 20 minutes, and a duty cycle of plasma pulse is 20 : 400; and
(5) Annealing: annealing the sample obtained in the step (4) at a temperature of 900°C for 30 minutes under nitrogen atmosphere. And a thickness of the annealed polysilicon film is 100 nm.

FIG. 2 shows an appearance view of the passivated contact structure of the TOPCon cell in Comparative Example 1 under a microscope.

### Comparative Example 2

This comparative example provides a method for preparing a passivated contact structure of a TOPCon cell. Comparative Example 2 is substantially the same as Comparative Example 1, except that in steps (4) and (5), a duty cycle of plasma pulse is 20 : 600;
in step (4), the deposition time of the intrinsic amorphous silicon thin film is 9 minutes and 36 seconds; and in step (5), the deposition time of the phosphorus-doped amorphous silicon thin film is 30 minutes.

FIG. 3 shows an appearance view of the passivated contact structure of the TOPCon cell in Comparative Example 2 under a microscope.

### Comparative Example 3

This comparative example provides a method for preparing a passivated contact structure of a TOPCon cell. Comparative Example 3 is substantially the same as Example 1, except that in step (2), placing a silicon wafer inside the furnace tube of the PECVD device, and then heating to 460°C.

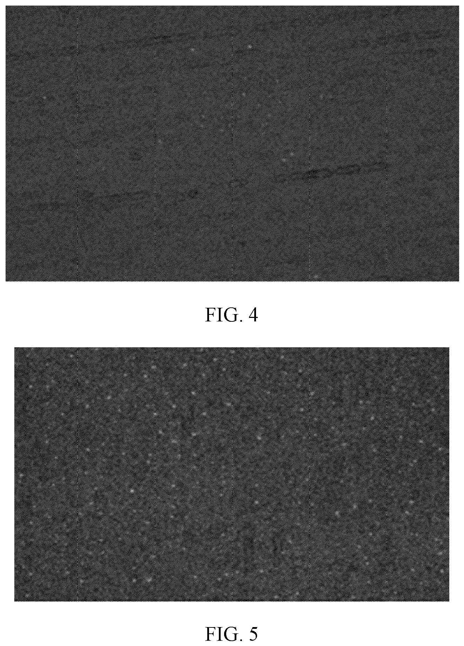

FIG. 4 shows an appearance view of the passivated contact structure of the TOPCon cell in Comparative Example 3 under a microscope.

### Comparative Example 4

This comparative example provides a method for preparing a passivated contact structure of a TOPCon cell. Comparative Example 4 is substantially the same as Example 1, except that in steps (4) and (5), a flow rate of SiH₄ is 2000 sccm.

FIG. 5 shows an appearance view of the passivated contact structure of the TOPCon cell in Comparative Example 4 under a microscope.

As shown in Example 1, Comparative Examples 1 to 4, FIGs. 1 to 4, in the process of preparing the passivated contact structures of the TOPCon cells, compared with Comparative Example 1, adjusting the deposition temperature of the tunnel oxide layer of comparative example 1 to comparative example 4 to be 460 °C, adjusting the flow rate of SiH₄ of the intrinsic amorphous silicon thin film and the doped amorphous silicon thin film to be 2000 sccm, and adjusting the duty ratio of plasma pulse of depositing the intrinsic amorphous silicon thin film and the doped amorphous silicon thin film to be 20 : 600 respectively mitigated the problem of film delamination. Furthermore, adjusting the deposition time of the intrinsic amorphous silicon thin film to be 9 minutes and 36 seconds and the deposition time of the phosphorus-doped amorphous silicon thin film to be 30 minutes was prone to mitigate the problem of film delamination. Compared to Comparative Example 1 to Comparative Example 4, the method in Example 1 effectively decreased the occurrence of film delamination. It illustrated that the method provided in the present application effectively decreased the occurrence of film delamination in the passivated contact structure of the tunnel oxide layer.

The foregoing is merely an alternative embodiment of the present application and is not intended to limit the present application, and for those skilled in the art, the present application may have various changes and changes. Any modification, equivalent replacement, improvement, etc. made within the spirit and principle of the present application shall fall within the protection scope of the present application.

### Industrial Applicability

The present application provides the methods for preparing the tunnel oxide layer and the amorphous silicon thin film and TOPCon cells. The thin film obtained by the method of the present application is relatively compact, and in the subsequent annealing process, hydrogen atoms can be released more effectively, significantly mitigating the problem of film delamination. At the same time, the thin film obtained by the method of the present application can prevent hydrogen atom from being stored within the thin film, and this effectively decreases the occurrence of film delamination resulting from hydrogen atoms accumulating and forming hydrogen gas in the later annealing process. The structure obtained by the method for preparing the tunnel oxide layer and the amorphous silicon thin film effectively mitigates the problem of film delamination, and can greatly improve the electrical performance thereof, and therefore has excellent industrial application performance.

## Claims

1. A method for preparing a tunnel oxide layer and an amorphous silicon thin film, comprising: sequentially depositing a tunnel oxide layer, an intrinsic amorphous silicon thin film and a doped amorphous silicon thin film at a deposition temperature of 440 °C to 460 °C by using a PECVD device,
wherein a flow rate of silane of depositing the intrinsic amorphous silicon thin film is in a range of 2000 sccm to 2500 sccm; and
a flow rate of silane of depositing the doped amorphous silicon thin film is in a range of 2000 sccm to 2500 sccm.

2. The method of claim 1, wherein a duty cycle of plasma pulse of depositing the intrinsic amorphous silicon thin film is 20: (500 - 600), and
a duty cycle of plasma pulse of depositing the doped amorphous silicon thin film is 20: (500 - 600).

3. The method of claims 1 or 2, wherein in a process of depositing the tunnel oxide layer, a flow rate of N₂O is in a range of 5500 sccm to 6500 sccm and a duty cycle of plasma pulse is 20: (900 - 1000).

4. The method of any one of claims 1-3, wherein after depositing the doped amorphous silicon thin film, the method further comprises: annealing for 20 minutes to 60 minutes at a temperature of 600 °C to 1000 °C under a nitrogen or oxygen atmosphere.

5. The method of any one of claims 1-4, wherein before depositing the tunnel oxide layer, the method further comprises: performing a vacuum pumping and leakage detection on a furnace tube of the PECVD device.

6. The method of any one of claims 1-5, wherein the doped amorphous silicon thin film is a phosphorus-doped amorphous silicon thin film, and
in a process of depositing the phosphorus-doped amorphous silicon thin film, a flow rate of phosphorus alkane is in a range of 2000 sccm to 2500 sccm, and a flow rate of hydrogen is in a range of 5000 sccm to 5500 sccm.

7. The method of any one of claims 1-5, wherein the doped amorphous silicon thin film is a nitrogen-doped amorphous silicon thin film, and
in a process of depositing the nitrogen-doped amorphous silicon thin film, a flow rate of methane is in a range of 450 sccm to 500 sccm and a flow rate of nitrogen is in a range of 1500 sccm to 2000 sccm.

8. A method for preparing a tunnel oxide layer and an amorphous silicon thin film, comprising: sequentially depositing a tunnel oxide layer, an intrinsic amorphous silicon thin film and a doped amorphous silicon thin film at a deposition temperature of 440 °C to 460 °C by using a PECVD device,
wherein a duty cycle of plasma pulse of depositing the intrinsic amorphous silicon thin film is 20: (500 - 600), and
a duty cycle of plasma pulse of depositing the doped amorphous silicon thin film is 20: (500 - 600).

9. A method for preparing a tunnel oxide layer and an amorphous silicon thin film, comprising: sequentially depositing a tunnel oxide layer, an intrinsic amorphous silicon thin film and a doped amorphous silicon thin film at a deposition temperature of 440 °C to 460 °C by using a PECVD device,
wherein in a process of depositing the intrinsic amorphous silicon thin film, a flow rate of silane is in a range of 2000 sccm to 2500 sccm, and a duty cycle of plasma pulse is 20: (500 - 600); and
in a process of depositing the doped amorphous silicon thin film, a flow rate of silane is in a range of 2000 sccm to 2500 sccm, and a duty cycle of plasma pulse is 20: (500 - 600).

10. A tunnel oxide layer and an amorphous silicon thin film, prepared by the method of any one of claims 1-9.

11. A TOPCon cell, wherein a tunnel oxide layer and an amorphous silicon thin film of the TOPCon cell are prepared by the method of any one of claims 1-9.

12. A TOPCon cell, comprising the tunnel oxide layer and the amorphous silicon thin film prepared by the method of any one of claims 1-9.
